# EUROPÄISCHE PATENTSCHRIFT

(11) **EP 3 231 079 B1**
(45) Veröffentlichungstag und Bekanntmachung des Hinweises auf die Patenterteilung: **26.06.2019**
(21) Anmeldenummer: 15784687.4
(22) Anmeldetag: 23.10.2015
(51) Int. Cl.: H02N 2/00

(54) **VERFAHREN UND VORRICHTUNG ZUR ANSTEUERUNG EINES PIEZOELEKTRISCHEN MOTORS**
METHOD AND APPARATUS FOR ACTIVATING A PIEZOELECTRIC MOTOR
PROCÉDÉ ET APPAREIL D'ACTIVATION D'UN MOTEUR PIEZOÉLÉCTRIQUE

(30) Priorität: 08.12.2014 DE 102014225154
(43) Veröffentlichungstag der Anmeldung: 18.10.2017
(73) Patentinhaber: Physik Instrumente (PI) GmbH & Co. KG, 76228 Karlsruhe (DE)
(72) Erfinder: STIEBEL, Christoph, 76337 Waldbronn (DE); WISCHNEWSKI, Alexej, 76744 Wörth (DE); WIENECKE, Dieter, 37136 Landolfshausen (DE); SINSKE, Kurt, 37130 Gleichen (DE)
(74) Vertreter: Grünecker Patent- und Rechtsanwälte PartG mbB
(86) Internationale Anmeldenummer: PCT/EP2015/074588
(87) Internationale Veröffentlichungsnummer: WO 2016/091443

(56) Entgegenhaltungen:
- DE-A1-102005 039 358
- DE-B3-102011 087 542
- US-B1- 7 075 211

## Beschreibung

Die Erfindung betrifft ein Verfahren gemäß dem Oberbegriff des unabhängigen Patentanspruchs1 und eine Vorrichtung zur Ansteuerung eines piezoelektrischen Motors mit zwei Ansteuerelektroden durch Anlegen von periodischen Steuerspannungen an die Ansteuerelektroden. Die Erfindung betrifft insbesondere das Gebiet von piezoelektrischen Ultraschallmotoren, die vorzugsweise im Frequenzbereich oberhalb von 20 kHz betrieben werden. Ein derartiges Verfahren ist aus der DE 10 2011 087542 B3 bekannt.

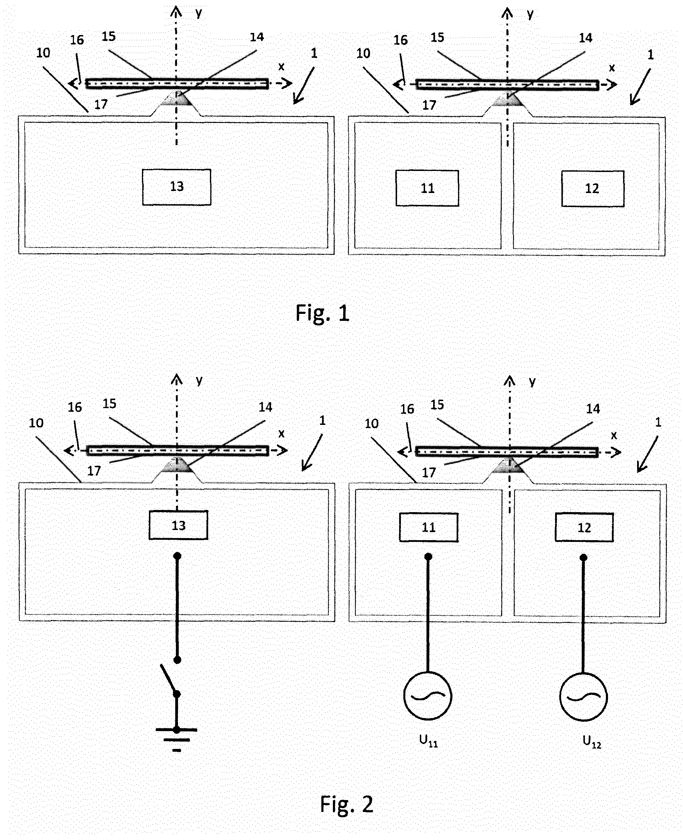

Ein piezoelektrischer Motor mit zwei Ansteuerelektroden, die durch periodische Steuerspannungen aus zwei getrennten Spannungsquellen gespeist werden, ist beispielsweise aus (Figur 1) der US 6,747,391 B1 bekannt.

Ein piezoelektrischer Motor funktioniert im Allgemeinen nach dem Prinzip, dass durch Anlegen von periodischen Steuerspannungen an dessen Ansteuerelektroden eine gezielte periodische Verformung eines piezokeramischen Elements (Aktor) erzeugt wird. Diese Verformung wird über ein sogenanntes Friktionselement (Reibnase) auf ein damit in Reibkontakt stehendes Abtriebselement übertragen, um einen Vortrieb dieses Abtriebselement zu erzeugen. Die Verformung bewirkt hierbei eine spezifische Bewegungsbahn des Friktionselements, die in der Regel eine elliptische Form aufweist, wobei die Hauptachse der Ellipse eine Neigung in die Richtung aufweist, in welche das Abtriebselement bewegt werden soll. Hierbei kann als Sonderfall die Nebenachse der Ellipse so klein sein, dass die Bewegungsbahn des Friktionselements in erster Näherung eine lineare bzw. gerade Form aufweist. Die entsprechende Bewegung des Friktionselements führt zu einem auf das Abtriebselement einwirkenden kurzen Impuls mit einer Geschwindigkeitskomponente, die in Antriebsrichtung des Abtriebselements weist. Die entsprechenden sich wiederholenden Impulse führen in ihrer Gesamtheit zu der gewünschten Bewegung des Abtriebselements.

Aufgrund sich örtlich und zeitlich variierender Eingriffs- bzw. Haftreibungsverhältnisse zwischen dem Friktionselement und der damit in Kontakt stehenden Oberfläche des Abtriebselements (im Folgenden auch als Reibfläche bezeichnet) kann es vorkommen, dass sich das Abtriebselement des Ultraschallmotors bei Anlegen einer Spannung mit einer bestimmten Amplitude bei einem Mal wie gewünscht bewegt, während es hingegen bei einem anderen Mal stehen bleibt. Letztlich handelt es sich hierbei um eine Nichtlinearität bzw. Hysterese bezüglich der Ansteuerspannungs-Geschwindigkeits-Kennlinie oder Übertragungskennlinie.

Im vorgenannten Falle, bei welchem das Abtriebselement bei einer bestimmten Ansteuerspannung stehen bleibt, sind die Eingriffs- bzw. Haftreibungsverhältnisse so, dass die angelegte Spannung bzw. deren Amplitude nicht ausreichend ist, um das Friktionselement aus der Haftreibung bzw. aus dem Eingriffsverhältnis zwischen ihm und der Reibfläche zu lösen bzw. das entsprechend benötigte Losbrechmoment oder die Losbrechspannung zu erzeugen.

Es existiert hierbei eine Schwellenamplitude der Spannung, oberhalb derer unabhängig von den Eingriffs- bzw. Haftreibungsverhältnissen eine Bewegung des Abtriebselements resultiert. Die Schwellenamplitude der Spannung liegt dabei in der Regel relativ hoch, woraus bestimmte Nachteile resultieren. Denn durch eine hohe Spannung folgt zum Einen ein hoher Energieverbrauch, zum Anderen jedoch ein entsprechend hoher Energieeintrag in das System aus Ultraschallaktor mit dem Friktionselement und dem Abtriebselement. Dieser hohe Energieeintrag führt dazu, dass bis zur eigentlichen Bewegung des Abtriebselements das System aus Ultraschallaktor und Abtriebselement quasi mechanisch vorgespannt wird, und beim Starten der Bewegung des Abtriebselements dieses eine entsprechend hohe Beschleunigung erfährt, welche regelungstechnisch schwer beherrschbar ist, insbesondere dann, wenn nur kleine Stellwege erzielt werden sollen bzw. das Abtriebselement mit einer sehr geringen Geschwindigkeit bewegt werden soll. Denn bei höheren Antriebsgeschwindigkeiten lässt sich der Ultraschallmotor trotz der weiterhin vorhandenen Nichtlinearität bzw. Hysterese bezüglich der Übertragungskennlinie durch Variation der Amplitude der Ansteuerspannung vergleichsweise einfach regeln, während bei niedrigen Antriebsgeschwindigkeiten, d.h. kleiner als 1mm/s, es sich kaum verhindern lässt, dass der Motor in das Regime des Losbrechmoments bzw. der Losbrechspannung gelangt, was letztlich zu Vibrationen und Positionsfehlern führen kann.

Die entsprechend hohe Nichtlinearität der Übertragungskennlinie, die im Regime der Losbrechspannung sog. Totbereiche aufweist, stellt das maßgebliche Problem für den positionsgeregelten Betrieb piezoelektrischer Ultraschallmotoren dar.

Der Erfindung liegt demnach die Aufgabe zu Grunde, ein Verfahren zur Ansteuerung eines piezoelektrischen Motors bereitzustellen, durch welches eine vereinfachte Positionsregelung insbesondere bei langsamen Antriebgeschwindigkeiten ermöglicht ist. Der Erfindung liegt weiterhin die Aufgabe zu Grunde, eine entsprechende Vorrichtung zur Ansteuerung eines piezoelektrischen Motors bereitzustellen.

Nach einem ersten Aspekt der Erfindung wird die vorstehend genannte Aufgabe gelöst durch das Verfahren nach Anspruch 1. Offenbart wird ein Verfahren zur Ansteuerung eines piezoelektrischen Motors mit wenigstens zwei Ansteuerelektroden durch Anlegen von periodischen Steuerspannungen an die Ansteuerelektroden, wobei in einem ersten Schritt des Verfahrens die periodischen Steuerspannungen mit einer Phasenverschiebung an die Ansteuerelektroden angelegt werden und in einem zweiten Schritt des Verfahrens das Amplitudenverhältnis der periodischen Steuerspannungen gegenüber dem ersten Schritt verändert wird.

Die Phasenverschiebung zwischen den beiden periodischen Steuerspannungen führt im ersten Schritt des Verfahrens zu einer Schwingung des Friktionselements im Wesentlichen entlang der Bewegungsbahn des anzutreibenden Abtriebselements, so dass sich der Reibkontakt zwischen Antrieb und Abtrieb aus seiner Haftreibung löst (sog. Kompensationsschwingung). Im Gegensatz zur phasengleichen Anregung beider Ansteuerelektroden, die eine Schwingung des Friktionselements auf einer stark exzentrischen elliptischen Bahn mit ihrer Hauptachse senkrecht zur Friktionsfläche führt, hat die phasenversetzte Ansteuerung außerdem den Vorteil einer kaum vorhandenen bzw. niedrigeren Schwingungskomponente senkrecht zur Friktionsfläche, was die Anregung störender Eigenschwingungen des Abtriebs wesentlich reduziert.

Im zweiten Schritt des Verfahrens wird die Neigung der Schwingungsbahn des Friktionselements durch Veränderung des Amplitudenverhältnisses der periodischen Steuerspannungen gegenüber dem ersten Schritt geändert, um den Vortrieb des Abtriebselements einzustellen. Die Reduktion der nichtlinearen Haftreibungsübergänge und insbesondere der damit verbundenen Hysterese der Übertragungskennlinie kommt einer Linearisierung der Regelstrecke gleich, so dass damit eine maßgebliche Verbesserung gegenüber bisherigen Methoden erzielt wird.

Ein ähnliches Phänomen ist aus der Praxis bekannt: ein auf einer vibrierenden Unterlage (z.B. Waschmaschine, Armaturenbrett eines fahrenden Fahrzeugs, etc.) positionierter Gegenstand kann gegenüber der Unterlage mit minimaler Krafteinwirkung bewegt werden, da aufgrund der Vibration der Unterlage keine oder eine vernachlässigbar kleine Haftkraft zwischen dem Gegenstand und der Unterlage vorliegt.

Vorteilhafte Weiterbildungen der Erfindung sind Gegenstände der abhängigen Ansprüche.

Vorzugsweise wird/werden im ersten Schritt des Verfahrens die Phasenverschiebung und/oder das Amplitudenverhältnis der periodischen Steuerspannungen derart eingestellt, dass ein Friktionselement des piezoelektrischen Motors zur Schwingung entlang einer Schwingungsbahn angeregt wird, die im Wesentlichen tangential oder exakt tangential zu einer Friktionsfläche eines durch das Friktionselement anzutreibenden Abtriebselements verläuft. Die Schwingungsbahn des Friktionselements verläuft im ersten Schritt des Verfahrens vorzugsweise waagrecht und/oder parallel zur Längsrandseite und/oder zu wenigstens einer der Flachseiten des piezokeramischen Elements (Aktor). Wenn das Abtriebselement auf einer waagerechten Bewegungsbahn läuft und keine auslenkenden Kräfte einwirken, befindet sich das Abtriebselement in diesem Fall im Kräftegleichgewicht entlang seiner Bewegungsfreiheitsgrade und schwebt nahezu kontaktfrei zum Friktionselement auf der Stelle, ohne sich zu bewegen. Im "Schwebezustand" befindet sich das Abtriebselement im Kräftegleichgewicht, d.h. die Summe der einwirkenden Kräfte entlang der Bewegungsfreiheitsgrade des Abtriebselements addiert sich zu null. In diesem sog. "Schwebezustand" genügt bereits ein äußerst kleiner Impuls, um das Abtriebselement in eine bestimmte Richtung zu bewegen. Durch ein geringfügiges Neigen der Hauptachse der Schwingungsbahn des Friktionselements, das über die Einstellung des Amplitudenverhältnisses der periodischen Steuerspannungen erzielt wird, kann das Abtriebselement aus diesem sog. "Schwebezustand" auch mit geringer Geschwindigkeit über kurze Distanzen bewegt werden. Ein Positionsfehler des Abtriebselements kann demnach auch bei kleinen Verstellwegen und/oder kleinen Geschwindigkeiten minimiert werden.

Es kann von Vorteil sein, wenn im ersten Schritt des Verfahrens die Phasenverschiebung und/oder das Amplitudenverhältnis der periodischen Steuerspannungen derart eingestellt wird/werden, dass ein Reibkontakt zwischen einem Friktionselement des piezoelektrischen Motors und einem durch das Friktionselement anzutreibenden Abtriebselement aus seiner Haftreibung gelöst wird, ohne gleichzeitig einen Vortrieb des Abtriebselements zu erzeugen. Es liegt im Rahmen der Erfindung, nicht nur den einfachen Fall zu berücksichtigen, dass die Friktionsfläche bzw. die Bewegungsbahn des anzutreibenden Abtriebselements exakt waagerecht ausgerichtet ist und keine auslenkenden Kräfte auf das anzutreibende Abtriebselement wirken. Auf das Abtriebselement können jedoch beispielsweise die Gewichtskraft oder andere Kräfte (zum Beispiel Vorspannung durch eine Feder) einwirken, z.B. wenn die Friktionsfläche bzw. die Bewegungsbahn des Abtriebselements geneigt ist. Eine gegenphasige Anregung der Ansteuerelektroden (Phasenverschiebung = 180°) mit gleicher Frequenz (z.B. 156 kHz) und Amplitude (d.h., das Amplitudenverhältnis = 1) löst den Reibkontakt zwischen An- und Abtrieb aus der Haftreibung. Das Abtriebselement würde sich aufgrund der auslenkenden Kräfte bewegen, da bei Aufhebung der Haftreibung die Summe der einwirkenden Kräfte entlang der Bewegungsfreiheitsgrade des Abtriebselements nicht gleich Null ist. Durch eine gezielte Ansteuerung der Ansteuerelektroden mit einem bestimmten Amplitudenverhältnis und/oder einer bestimmten Phasenverschiebung der periodischen Steuerspannungen kann diese auslenkende Kraft kompensiert werden, so dass sich die auf das Abtriebselement einwirkenden Kräfte entlang der Bewegungsfreiheitsgrade des Abtriebselements zu Null addieren. Demnach ist es in Abhängigkeit des jeweiligen Ultraschallmotorsystems gegebenenfalls erforderlich, die Phasenverschiebung und/oder das Amplitudenverhältnis der an die Ansteuerelektroden anzulegenden Steuerspannungen anzupassen, um eine der auslenkenden Kraft entgegen wirkende Kraft zu erzeugen, so dass das Abtriebselement ohne Vortrieb im "Schwebezustand" gehalten wird.

Es kann zudem vorteilhaft sein, wenn im zweiten Schritt des Verfahrens die Phasenverschiebung und/oder das Amplitudenverhältnis der periodischen Steuerspannungen derart gegenüber dem ersten Schritt geändert wird/werden, dass sich die Schwingungsbahn des Friktionselements gegenüber dem ersten Schritt neigt und dadurch ein Vortrieb des Abtriebselements erzeugt wird. Dadurch können die Geschwindigkeit und die Bewegungsrichtung des Abtriebselements beeinflusst werden.

Zudem kann es sich als sinnvoll erweisen, wenn im ersten Schritt und/oder im zweiten Schritt des Verfahrens die periodischen Steuerspannungen mit konstanter Phasenverschiebung an die Ansteuerelektroden angelegt werden, wobei die Phasenverschiebung vorzugsweise im Wesentlichen gleich 180° oder exakt gleich 180° ist. Die Phasenverschiebung von 180° zwischen den beiden periodischen Steuerspannungen führt im Falle gleicher Amplituden und gleicher, bestimmter Frequenz (z.B. 156 kHz) zu einer Schwingung des Friktionselements auf einer stark exzentrischen elliptischen Bahn mit ihrer Hauptachse tangential zur Friktionsfläche. Durch diese hochfrequente Schwingung tangential zur Friktionsfläche wird der Reibkontakt aus seiner Haftreibung gelöst, ohne gleichzeitig einen Vortrieb zu erzeugen. Unter Beibehaltung der konstanten Phasenverschiebung zwischen den periodischen Steuerspannungen kann durch Veränderung des Amplitudenverhältnisses der periodischen Steuerspannungen gezielt die Neigung der Schwingungsbahn des Friktionselements des piezoelektrischen Motors verändert werden, ohne eine gegebenenfalls ungewollte weitere Bewegungskomponente zu erhalten.

Überdies kann es von Vorteil sein, wenn im ersten Schritt des Verfahrens das Amplitudenverhältnis der periodischen Steuerspannungen konstant ist, vorzugsweise im Wesentlichen gleich 1 oder exakt gleich 1 ist. Wenn die Friktionsfläche und die Bewegungsbahn des Abtriebselements waagrecht verlaufen und keine auslenkenden Kräfte auf das Abtriebselement einwirken, wird der vortriebslose Schwebezustand durch ein ausgeglichenes Amplitudenverhältnis von 1 erreicht. Falls auslenkende Kräfte auf das Abtriebselement einwirken, wird der Schwebezustand, in welchem der Reibkontakt zwischen dem Friktionselement und dem Abtriebselement aus der Haftreibung gelöst ist und das Abtriebselement an derselben Stelle verharrt, gegebenenfalls durch Einstellung einer bestimmten Neigung der Schwingungsbahn des Friktionselement erreicht.

Es kann sich als vorteilhaft erweisen, wenn im zweiten Schritt des Verfahrens das Amplitudenverhältnis der periodischen Steuerspannungen ausgehend von einem ersten Wert kontinuierlich auf einen zweiten Wert verändert wird, wobei der erste Wert vorzugsweise dem Amplitudenverhältnis der periodischen Steuerspannungen im ersten Schritt entspricht. Die Neigung der Schwingungsbahn des Friktionselements wird durch das Amplitudenverhältnis der periodischen Steuerspannungen eingestellt. Eine kontinuierliche Veränderung des Amplitudenverhältnisses bewirkt demnach eine kontinuierliche Veränderung der Neigung der Schwingungsbahn des Friktionselements. Aufgrund der nicht oder kaum vorhandenen Haftreibung zwischen dem Friktionselement und dem Abtriebselement im Schwebezustand kann das Abtriebselements bereits durch geringfügige Neigung der Schwingungsbahn des Friktionselement in Bewegung versetzt werden. So kann im Ergebnis ein sanftes Anfahren des Abtriebselements ohne ruckartige Bewegungen erzielt werden. Dadurch sind auch kleine Verstellwege und/oder geringe Vortriebsgeschwindigkeiten des Abtriebselements darstellbar.

Des weiteren kann es sich als nützlich erweisen, wenn im ersten Schritt und/oder im zweiten Schritt des Verfahrens die periodischen Steuerspannungen im Wesentlichen die gleiche oder exakt die gleiche Frequenz aufweisen, wobei diese Frequenz vorzugsweise höher ist als die elektrische Resonanzfrequenz eines piezokeramischen Elements des piezoelektrischen Motors bzw. eines Ultraschallaktors im Ultraschallmotorsystem.

Der piezoelektrische Motor bzw. der piezoelektrische Ultraschallaktor kann im Bereich seiner jeweiligen Ansteuerelektrode als Generator für eine akustische Stehwelle angesehen werden, so dass der entsprechende Bereich einen Teilaktor darstellt. Jeder der beiden Teilaktoren stellt eine Impedanz dar, die bei Anregung mit der Resonanzfrequenz einen ohmschen Widerstand bildet.

Die periodischen Steuerspannungen werden über wenigstens eine in Frequenz, Amplitude und Phase einstellbare Quelle an diese Teilaktoren angelegt. Beim Betreiben des Ultraschallmotors mit periodischen Steuerspannungen, deren Frequenz der Resonanzfrequenz des piezoelektrischen Motors bzw. des piezoelektrischen Ultraschallaktors entspricht, würde der Strom von einer Quelle über die beiden Impedanzen in die andere, mit 180° Phasenverschiebung angesteuerte Quelle laufen. Kleine Frequenzverschiebungen im Bereich um die Resonanzfrequenz führen jedoch zu Phasendrehungen zwischen Spannung und Strom von +/- 180°, wodurch sich der oben skizzierte und vorteilhafte Stromfluss nicht stabil einstellen lässt. Hierbei ist zu beachten, dass die Resonanzfrequenz des piezoelektrischen Ultraschallaktors keine Konstante ist, sondern sich abhängig von den mechanischen und thermischen Randbedingungen ändert. Diese Änderung führt in analoger Weise zu der oben beschriebenen nachteiligen Phasendrehung zwischen Spannung und Strom. Daher wird die Frequenz zur Ansteuerung des piezoelektrischen Ultraschallaktors so gewählt, dass sich die Phasendrehung zwischen Ansteuerspannung und Strom mit der sich variierenden Resonanzfrequenz nur noch geringfügig ändert.

Eine Anregung außerhalb und insbesondere nahe der Resonanzfrequenz ist somit unempfindlicher gegenüber einer zwangsläufig immer vorhandenen Variation der elektro-mechanischen Resonanzfrequenz des Aktorsystems. Dies ist die Voraussetzung dafür, dass auch der Schwingungsvektor der Bewegung des Friktionselements stabil eingestellt werden kann. Zwar ist die Schwingungsamplitude in der Resonanzfrequenz am größten, jedoch ist der Bewegungsvektor im Bereich der Resonanzfrequenz nicht zielgerichtet.

Die eingangs genannte Aufgabe der Erfindung wird nach einem zweiten Aspekt der Erfindung gelöst durch die Vorrichtung nach Anspruch 7. Offenbart wird eine Vorrichtung zur Ansteuerung eines piezoelektrischen Motors mit wenigstens zwei Ansteuerelektroden durch Anlegen von periodischen Steuerspannungen an die Ansteuerelektroden, wobei die Vorrichtung derart konfiguriert ist, um automatisch das Verfahren nach einer der vorangehenden Ausführungen auszuführen. Erfindungsgemäß ist diese Vorrichtung nicht nur dazu geeignet, sondern dazu eingerichtet bzw. konfiguriert, um selbsttätig bzw. automatisch das Verfahren nach einer der vorangehenden Ausführungen durchzuführen, insbesondere wenn (z.B. durch einen Benutzer oder ein Steuergerät) ein Vortrieb des Abtriebselements des piezoelektrischen Motors angefordert wird.

Es kann von Vorteil sein, wenn die Vorrichtung ein Steuergerät aufweist, welches derart konfiguriert ist, um zunächst die periodischen Steuerspannungen mit einer Phasenverschiebung an die Ansteuerelektroden anzulegen und anschließend das Amplitudenverhältnis der periodischen Steuerspannungen gegenüber dem ersten Schritt zu verändern, vorzugsweise wenn ein Vortrieb des piezoelektrischen Motors angefordert wird. Das Steuergerät ist vorzugsweise derart programmiert, dass es insbesondere beim Anfahren des Abtriebselements zunächst (im ersten Schritt des Verfahrens) über eine Steuerung der Phasenverschiebung und des Amplitudenverhältnisses der periodischen Steuerspannungen (z. B. aus zwei getrennten Spannungsquellen) eine Schwingung des Friktionselements erzeugt, die zu einer Aufhebung der Haftreibung zwischen dem Friktionselement und dem Abtriebselement führt, ohne Vortrieb zu erzeugen (Schwebezustand), um anschließend (im zweiten Schritt des Verfahrens) durch eine Veränderung des Amplitudenverhältnisses die Schwingungsbahn des Friktionselement derart zu verändern, dass ein Vortrieb des Abtriebselements erzielt wird.

Weitere vorteilhafte Weiterbildungen der Erfindung ergeben sich durch beliebige Kombinationen der in der Beschreibung, den Ansprüchen und den Zeichnungen offenbarten Merkmale

### Kurze Beschreibung der Figuren

Es zeigen:
- Fig. 1: eine schematische Ansicht eines piezoelektrischen Motors zur Benennung der Elektroden.
- Fig. 2: eine schematische Ansicht des piezoelektrischen Motors aus Figur 1 mit periodischen Steuerspannungen (sinusförmigen Wechselspannungen) auf den sog. Ansteuerelektroden, während die sog. Masseelektrode geerdet ist.

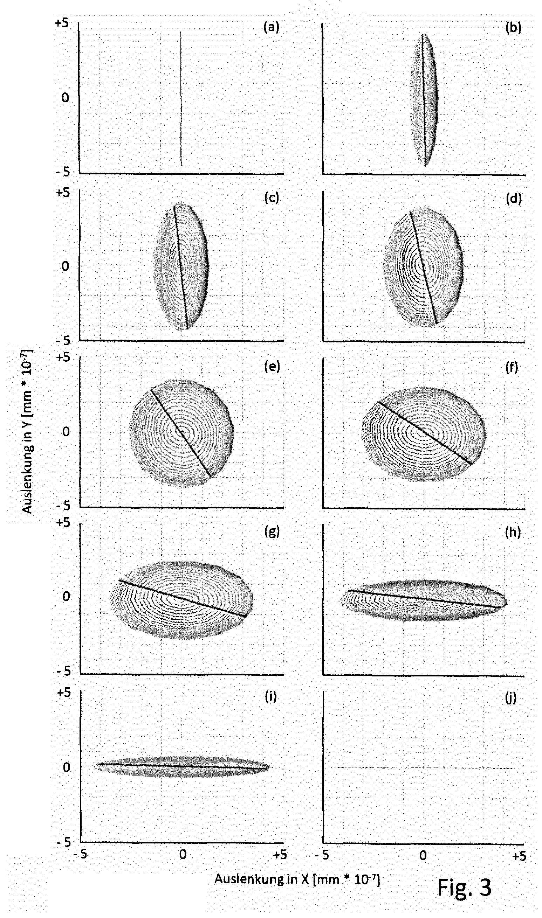

- Fig. 3: Diagramme zur Darstellung einer Variation der Phasendifferenz der an den Ansteuerelektroden anliegenden Steuerspannungen im Bereich von 0 bis 1 von oben links (a) bis unten rechts (j), wobei sich die Hauptachse der Schwingungsbahn des Friktionselements bei fortschreitender Neigung der Ellipse gegen den Uhrzeigersinn im Uhrzeigersinn dreht. Die einzelnen Diagramme (a) bis (j) zeigen dabei den Verlauf der Schwingungsbahn des Friktionselements im X-Y-Koordinatensystem mit Auslenkung tangential (X-Richtung; sh. Fig. 1 und 2) und quer zur Friktionsfläche des Abtriebselements (Y-Richtung; sh. Fig. 1 und 2) in Abhängigkeit der eingestellten Phasendifferenz.

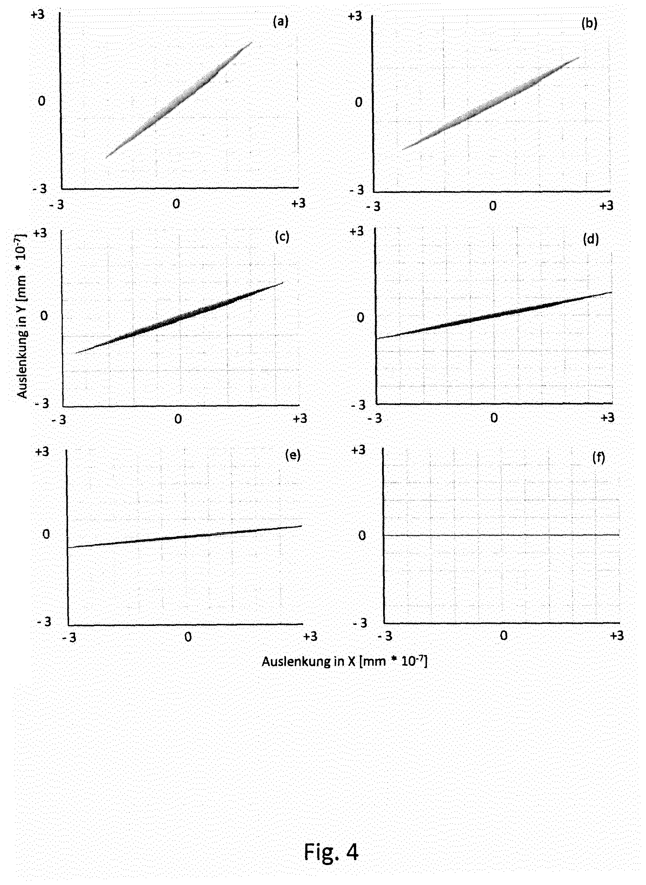

- Fig. 4: Diagramme zur Darstellung einer Variation der Amplitude der Anregung einer der beiden Ansteuerelektroden bei ständig voll angesteuerter anderer Ansteuerelektrode im Bereich von 0% bis 100% bei einer Phasendifferenz von 180° bzw. π von oben links (a) bis unten rechts (f), wobei die Auslenkung des Friktionselements in Y-Richtung bei einem Amplitudenverhältnis von 1 (Fig. 4 (f)) gleich 0 ist und demnach die Schwingungsbahn des Friktionselements tangential zur Friktionsfläche verläuft. Die einzelnen Diagramme (a) bis (j) zeigen dabei den Verlauf der Schwingungsbahn des Friktionselements im X-Y-Koordinatensystem mit Auslenkung tangential (X-Richtung; sh. Fig. 1 und 2) und quer zur Friktionsfläche des Abtriebselements (Y-Richtung; sh. Fig. 1 und 2) in Abhängigkeit des eingestellten Amplitudenverhältnisses.

### Detaillierte Beschreibung des bevorzugten Ausführungsbeispiels

Die Erfindung betrifft ein Verfahren und eine Vorrichtung zur Ansteuerung eines piezoelektrischen Motors 1 mit zwei Ansteuerelektroden 11, 12 durch Anlegen von periodischen Steuerspannungen an die Ansteuerelektroden 11, 12. Es handelt sich insbesondere um einen piezoelektrischen Ultraschallmotor mit einem piezoelektrischen Ultraschallaktor, der mit einer Frequenz von beispielsweise 156 kHz betrieben wird.

Ein piezoelektrischer Ultraschallmotor 1, auf den das erfindungsgemäße Verfahren Anwendung findet, wird nachstehend mit Bezug auf die Figuren 1 und 2 beschrieben.

Der piezoelektrische Ultraschallmotor 1 umfasst insgesamt drei Elektroden 11, 12, 13. Zwei dieser Elektroden 11, 12 befinden sich an einer der beiden Flachseiten eines in etwa quaderförmigen, piezokeramischen Elements 10 (Abmessung z.B. 25mm x 11mm x 4mm) und besitzen im Wesentlichen quadratische Flächen gleicher Abmessung (z.B. 10mm x 10mm) und Größe (z.B. 100 mm²). Diese flachseitig angebrachten Elektroden 11, 12 sind über ein Steuergerät (nicht gezeigt) an Quellen zur Erzeugung von periodischen Wechselspannungen (periodische Steuerspannungen) U11, U12 angeschlossen und werden daher auch als Ansteuerelektroden 11, 12 bezeichnet. Die auf der gegenüberliegenden Flachseite des piezokeramischen Elements 10 angeordnete Elektrode 13 ist geerdet bzw. an Masse angeschlossen und wird demnach als sogenannte Masseelektrode 13 bezeichnet. Gegebenenfalls kann ein (im Vergleich zur Aktorimpedanz) niederohmiger Widerstand (zum Beispiel Kondensator), zwischengeschaltet werden, so dass die Elektrode 13 nicht notwendigerweise geerdet sein muss.

Jede Ansteuerelektrode 11, 12 bedeckt im Wesentlichen eine Hälfte dieser Flachseite des piezokeramischen Elements 10, wobei zwischen den Ansteuerelektroden zumindest ein schmaler Trennbereich zur elektrischen Isolation vorgesehen ist. Die Ansteuerelektroden 11, 12 sind symmetrisch zu einer gedachten Mittellinie angeordnet, die durch ein längsrandseitig und mittig des piezokeramischen Elements 10 angeordnetes Friktionselement 14 (Reibnase) verläuft und eine Y-Achse des Aktorsystems definiert. Die Masseelektrode 13 (Abmessung z.B. 20mm x 10mm) bedeckt im Wesentlichen die gesamte Fläche der anderen Flachseite des piezokeramischen Elements 10.

Durch gezielte Ansteuerung der Ansteuerelektroden 11, 12 über das Steuergerät mit periodischen Steuerspannungen U11, U12 wird das piezokeramische Element 10 mit elektrischer Spannung beaufschlagt. Aufgrund der piezoelektrischen Eigenschaft des piezokeramischen Elements 10 wird die elektrische Spannung in eine periodische mechanische Verformung umgesetzt, was zu einer Schwingung des Friktionselements 14 führt. In Abhängigkeit der Phasen, Amplituden und Frequenzen der periodischen Steuerspannungen U11, U12 weist die Schwingungsbahn Bewegungskomponenten in X-Richtung und/oder in Y-Richtung auf.

An das Friktionselement 14 ist über einen Reibkontakt ein anzutreibendes Abtriebselement 15 gekoppelt, dass sich entlang einer Bewegungsbahn 16 bewegen kann, die eine X-Richtung definiert. Diese Bewegungsbahn 16 ist vorzugsweise in etwa oder exakt parallel zur Längsrandseite des piezokeramischen Elements 10 ausgerichtet, von welcher das Friktionselement 14 hervorsteht. Die mit dem Friktionselement 14 in Reibkontakt stehende Seite des Abtriebselements 15 wird im Folgenden auch als Friktionsfläche 17 bezeichnet. Im vorliegenden Fall kann davon ausgegangen werden, dass die Bewegungsbahn 16 in einer horizontalen Ebene angeordnet ist und parallel zur Längsrandseite sowie parallel zu den beiden mit den Elektroden 11, 12, 13 bestückten Flachseiten des piezokeramischen Elements 10 verläuft. Ferner kann im vorliegenden Fall davon ausgegangen werden, dass keine auslenkenden Kräfte auf das Abtriebselement 15 einwirken. Demnach verharrt das Abtriebselement 15 im Kräftegleichgewicht an selber Stelle, wenn der Reibkontakt zwischen dem Friktionselement 14 und dem Abtriebselement 15 aus der Haftreibung gelöst wird.

Wird im Einklang mit einem Steuersignal, das von dem Steuergerät erhalten wird, eine periodische Steuerspannung U11 oder U12 zwischen einer der Elektroden 11 oder 12 und der Elektrode 13 angelegt, so bewirkt diese Steuerspannung U11, U12 eine mechanische Verschiebung des an das Friktionselement 14 gekoppelten Abtriebselements 15 in einer ersten Richtung entlang der Bewegungsbahn 16. Das Anlegen einer periodischen Steuerspannung U12 zwischen der anderen Elektrode 12 oder 11 und der Elektrode 13 bewirkt eine mechanische Verschiebung des Abtriebselements 15 in einer entgegengesetzten Richtung entlang der Bewegungsbahn 16.

Das Steuergerät ist derart ausgebildet, um die Phasen, Frequenzen und Amplituden der periodischen Steuerspannungen U11, U12 unabhängig voneinander variieren zu können. Insbesondere können die periodischen Steuerspannungen U11, U12 phasenverschoben und amplitudenmodulierbar (d.h. mit veränderbarem Amplitudenverhältnis) an die Ansteuerelektroden 11, 12 angelegt werden. Dadurch kann der piezoelektrische Motor 1 in unterschiedlichen Betriebsbereichen optimiert werden und eine geringere Reibung sowie ein verbessertes Regelverhalten erzielt werden.

Das erfindungsgemäße Verfahren sieht vor, für besonders kritische Betriebssituationen des piezoelektrischen Motors 1 eine möglichst günstige Kombination im Parameterraum auszuwählen, um eine verbesserte Steuercharakteristik sowie ein besseres Regelverhalten zu erzielen. Dies gilt insbesondere für den Fall eines Vortriebs des Abtriebselements 15 mit geringem Verstellweg und/oder mit geringer Geschwindigkeit, in dem das erfindungsgemäße Verfahren eine erleichterte Reglerstabilisierung ermöglicht.

Die Fig. 3 und 4 zeigen Diagramme zur Darstellung, wie sich Variationen der Phasendifferenz und des Amplitudenverhältnisses zwischen den an den Ansteuerelektroden 11, 12 anliegenden, periodischen Steuerspannungen U11, U12 beispielsweise auf die Schwingungsbahn des Friktionselements 14 des piezoelektrischen Motors 1 im X-Y-Koordinatensystem auswirken.

Das erfindungsgemäße Verfahren umfasst folgende Schritte:
Im ersten Schritt des Verfahrens werden ausgehend von einem elektrisch spannungsfreien Zustand über das Steuergerät gleichzeitig periodische Wechselspannungen U11, U12 mit gleicher Frequenz von jeweils 156 kHz, einer Phasenverschiebung von 180° (bzw. π) und einem Amplitudenverhältnis von eins, an die Ansteuerelektroden 11, 12 angelegt. Die gegenphasige Ansteuerung beider Ansteuerelektroden 11, 12 mit gleicher Frequenz und Amplitude bewirkt, dass das Friktionselement 14 auf einer stark exzentrischen elliptischen Bahn mit ihrer Hauptachse tangential zur Friktionsfläche 17 schwingt, so dass der Reibkontakt zwischen dem Friktionselement 14 und dem Abtriebselement 15 aus seiner Haftreibung gelöst wird. Wenn keine auslenkenden Kräfte auf das Abtriebselement 15 einwirken, wird dabei kein Vortrieb erzeugt. In diesem Zustand verharrt das Abtriebselement 15 nahezu kontaktfrei und "schwebend" an selber Stelle, so dass dieser Zustand auch als "Schwebezustand" bezeichnet wird.

Im zweiten Schritt des Verfahrens wird durch Ändern des Amplitudenverhältnisses der an den Ansteuerelektroden 11, 12 anliegenden periodischen Steuerspannungen U11, U12 die elliptische Bahn, entlang der das Friktionselement 14 schwingt, geneigt. In Folge dessen wird das Abtriebselement 15 in Bewegung versetzt. Die Neigung der Bahn und der daraus resultierende Vortrieb lassen sich über das Amplitudenverhältnis steuern. Das Amplitudenverhältnis wird vorzugsweise ausgehend von einem Wert von 1 kontinuierlich oder stetig d.h. nicht sprunghaft verändert, wobei die Amplitude der an einer Ansteuerelektrode 11, 12 anliegenden, periodischen Steuerspannung U11 vorzugsweise konstant bleibt und die Amplitude der an einer anderen Ansteuerelektrode 12 anliegenden, periodischen Steuerspannung U12 verändert wird.

In einem optionalen dritten Schritt kann bei Erreichen eines "Zielfensters" (d.h. wenn sich das Abtriebselement 15 in der Nähe einer erwünschten Zielposition befindet und der Abstand zur Zielposition vorzugsweise im Bereich von Nanometern liegt) durch gezieltes Zurücknehmen der für den "Schwebezustand" erforderlichen "Kompensations"-Schwingung der Zustand maximaler Haftreibung wieder in vollem Umfang hergestellt werden, wodurch der Vorteil eines stromlosen, selbsthaltenden Aktors im Stillstand erzielbar ist.

Eine erfindungsgemäße Vorrichtung ist derart konfiguriert, um insbesondere in dem Fall, dass ein Vortrieb des piezoelektrischen Motors 1 angefordert wird, automatisch das erfindungsgemäße Verfahren mit beiden vorstehend genannten Verfahrensschritten ausgeführt wird. Eine erfindungsgemäße Vorrichtung ist beispielsweise als Steuergerät konfiguriert, das mit einem piezoelektrischen Motor 1 mit zwei Ansteuerelektroden 11, 12 gekoppelt werden kann, um die Ansteuerelektroden 11, 12 mit periodischen Steuerspannungen U11, U12 (z. B. aus getrennten Spannungsquellen) zu speisen.

Wenn beispielsweise ein Benutzer einen Vortrieb des Abtriebselements 15 über das Steuergerät anfordert, werden die periodischen Steuerspannungen U11, U12 über das Steuergerät phasenverschoben mit gleicher Frequenz und Amplitude an die Ansteuerelektroden 11, 12 angelegt, um den "Schwebezustand" des Abtriebselements 15 herbeizuführen. Ausgehend von diesem Zustand moduliert das Steuergerät das Amplitudenverhältnis der an den Ansteuerelektroden 11, 12 anliegenden Steuerspannungen U11, U12 selbsttätig und ohne weiteres Zutun des Benutzers, so dass die oben beschriebene Neigung der Schwingungsebene des Friktionselements 14 erzielt wird und sich ein Vortrieb des Abtriebselements 15 in der vom Benutzer angeforderten Richtung und Geschwindigkeit einstellt.

Im Ergebnis kann durch die erfindungsgemäße Vorrichtung die Problematik des sprunghaften und nichtlinearen Haftreibungsübergangs beim Anfahren des piezoelektrischen Motors 1, insbesondere bei geringen Verstellwegen und niedrigen Geschwindigkeiten, überwunden werden, so dass im Vergleich zu herkömmlichen Vorrichtungen eine höhere Positionsgenauigkeit bei der Positionierung des Abtriebselements erzielt werden kann.

In Anwendung der erfindungsgemäßen Lehre können beispielsweise selbsthemmende Systeme bereitgestellt werden, die im Normalzustand spannungsfrei sind. Durch Anlegen einer sogenannten Kompensationsspannung wird der Schwebezustand des Abtriebselements 15 herbeigeführt und der selbsthemmende Zustand aufgehoben. Bei Ausbleiben der Kompensationsspannung wird der selbsthemmende Zustand wiederhergestellt. Demnach ist das selbsthemmende System nur dann mit Spannung zu beaufschlagen, wenn ein Vortrieb des Abtriebselements 15 erzeugt und/oder dessen Position korrigiert werden soll, und kann im Übrigen spannungsfrei gehalten werden. Dadurch kann ein selbsthemmendes System im Einklang mit der Erfindung mit minimalem Energieaufwand betrieben werden.

### Bezugszeichenliste

- 1:: Piezoelektrischer Motor
- 10:: Piezokeramisches Element
- 11:: Ansteuerelektrode
- 12:: Ansteuerelektrode
- 13:: Masseelektrode (geerdet)
- 14:: Friktionselement
- 15:: Abtriebselement
- 16:: Bewegungsbahn des Abtriebselements
- 17:: Friktionsfläche
- U11:: Periodische Steuerspannung
- U12:: Periodische Steuerspannung

## Patentansprüche

1. Verfahren zur Ansteuerung eines piezoelektrischen Motors (1) mit wenigstens zwei Ansteuerelektroden (11, 12) durch Anlegen von periodischen Steuerspannungen an die Ansteuerelektroden (11, 12), wobei in einem ersten Schritt des Verfahrens die periodischen Steuerspannungen (U₁₁, U₁₂) mit einer Phasenverschiebung an die Ansteuerelektroden (11, 12) angelegt werden und in einem zweiten Schritt des Verfahrens das Amplitudenverhältnis der periodischen Steuerspannungen (U₁₁, U₁₂) gegenüber dem ersten Schritt verändert wird, **dadurch gekennzeichnet, dass** im ersten Schritt des Verfahrens die Phasenverschiebung und/oder das Amplitudenverhältnis der periodischen Steuerspannungen (U₁₁, U₁₂) derart eingestellt wird/werden, dass die Haftreibung eines Reibkontakts zwischen einem Friktionselement (14) des piezoelektrischen Motors (1) und einem durch das Friktionselement (14) anzutreibenden Abtriebselement (15) reduziert wird, ohne gleichzeitig einen Vortrieb des Abtriebselements (15) zu erzeugen, wobei keine auslenkenden Kräfte auf das Abtriebselement (15) einwirken und sich dieses im Kräftegleichgewicht entlang seiner Bewegungsfreiheitsgrade befindet, und dass im zweiten Schritt des Verfahrens die Phasenverschiebung und/oder das Amplitudenverhältnis der periodischen Steuerspannungen (U₁₁, U₁₂) derart gegenüber dem ersten Schritt geändert wird/werden, dass sich die Schwingungsbahn des Friktionselements (14) gegenüber dem ersten Schritt neigt und dadurch ein Vortrieb des Abtriebselements (15) erzeugt wird.

2. Verfahren nach Anspruch 1, **dadurch gekennzeichnet, dass** im ersten Schritt des Verfahrens die Phasenverschiebung und/oder das Amplitudenverhältnis der periodischen Steuerspannungen (U₁₁, U₁₂) derart eingestellt wird/werden, dass ein Friktionselement (14) des piezoelektrischen Motors (1) zur Schwingung entlang einer Schwingungsbahn angeregt wird, die im Wesentlichen tangential oder exakt tangential zu einer Friktionsfläche (17) eines durch das Friktionselement (14) anzutreibenden Abtriebselements (15) verläuft.

3. Verfahren nach einem der vorangehenden Ansprüche, **dadurch gekennzeichnet, dass** im ersten Schritt und/oder im zweiten Schritt des Verfahrens die periodischen Steuerspannungen (U₁₁, U₁₂) mit konstanter Phasenverschiebung an die Ansteuerelektroden (11, 12) angelegt werden, wobei die Phasenverschiebung vorzugsweise im Wesentlichen gleich 180° oder exakt gleich 180° ist.

4. Verfahren nach einem der vorangehenden Ansprüche, **dadurch gekennzeichnet, dass** im ersten Schritt des Verfahrens das Amplitudenverhältnis der periodischen Steuerspannungen (U₁₁, U₁₂) konstant ist, vorzugsweise im Wesentlichen gleich 1 oder exakt gleich 1 ist.

5. Verfahren nach einem der vorangehenden Ansprüche, **dadurch gekennzeichnet, dass** im zweiten Schritt des Verfahrens das Amplitudenverhältnis der periodischen Steuerspannungen (U₁₁, U₁₂) ausgehend von einem ersten Wert kontinuierlich auf einen zweiten Wert verändert wird, wobei der erste Wert vorzugsweise dem Amplitudenverhältnis der periodischen Steuerspannungen (U₁₁, U₁₂) im ersten Schritt des Verfahrens entspricht.

6. Verfahren nach einem der vorangehenden Ansprüche, **dadurch gekennzeichnet, dass** im ersten Schritt und/oder im zweiten Schritt des Verfahrens die periodischen Steuerspannungen (U₁₁, U₁₂) im Wesentlichen die gleiche oder exakt die gleiche Frequenz aufweisen, wobei diese Frequenz außerhalb und vorzugsweise nahe bei der elektrischen Resonanzfrequenz eines piezokeramischen Elements des piezoelektrischen Motors (1) bzw. eines Ultraschallaktors im Ultraschallmotorsystem liegt.

7. Vorrichtung zur Ansteuerung eines piezoelektrischen Motors (1) mit wenigstens zwei Ansteuerelektroden (11, 12) durch Anlegen von periodischen Steuerspannungen an die Ansteuerelektroden (11, 12), **dadurch gekennzeichnet, dass** die Vorrichtung derart konfiguriert ist, um automatisch das Verfahren nach einem der vorangehenden Ansprüche auszuführen.

8. Vorrichtung nach Anspruch 7, **dadurch gekennzeichnet, dass** die Vorrichtung ein Steuergerät aufweist, welches derart konfiguriert ist, um zunächst die periodischen Steuerspannungen (U₁₁, U₁₂) mit einer Phasenverschiebung an die Ansteuerelektroden (11, 12) anzulegen und anschließend das Amplitudenverhältnis der periodischen Steuerspannungen (U₁₁, U₁₂) gegenüber dem ersten Schritt zu verändern, vorzugsweise wenn ein Vortrieb des piezoelektrischen Motors (1) angefordert wird.

## Claims

1. Method for controlling a piezoelectric motor (1) by way of at least two driving electrodes (11, 12) by applying periodic control voltages to said driving electrodes (11, 12), where in a first step of the method said periodic control voltages (U₁₁, U₁₂)) are applied with a phase shift to said driving electrodes (11, 12), and in a second step of the method, the amplitude ratio of said periodic control voltages (U₁₁, U₁₂) is changed with respect to the first step, **characterized in that**, in the first step of the method the phase shift and/or the amplitude ratio of said periodic control voltages (U₁₁, U₁₂) is/are adjusted such that the static friction of said friction contact between a friction element (14) of said piezoelectric motor (1) and an output element (15) to be driven by said friction element (14) is reduced without creating a propulsion of said output element (15) at the same time, wherein no deflecting forces are applied to said output element (15) and said output element (15) is in force equilibrium along its degrees of freedom of movement, and **in that**, in the second step of the method, the phase shift and/or the amplitude ratio of said periodic control voltages (U₁₁, U₁₂) is/are changed in such a way with regard to the first step that the vibration path of said friction element (14) inclines as compared to the first step and thereby produces a propulsion of said output element (15).

2. Method according to claim 1, **characterized in that** in a first step of the method the phase shift and/or the amplitude ratio of said periodic control voltages (U₁₁, U₁₂) are adjusted in such a manner that a friction element (14) of said piezoelectric motor (1) is excited to vibrate along a vibration path which extends substantially tangential or exactly tangential to a friction surface (17) of an output element (15) to be driven by said friction element (14).

3. Method according to one of the preceding claims, **characterized in that** in the first step and/or in the second step of the method said periodic control voltages (U₁₁, U₁₂) are applied to said driving electrodes (11, 12) with a constant phase shift, where the phase shift is preferably substantially equal to 180° or exactly equal to 180°.

4. Method according to one of the preceding claims, **characterized in that** in the first step of the method the amplitude ratio of said periodic control voltages (U₁₁, U₁₂) is constant, preferably substantially equal to 1 or exactly equal to 1.

5. Method according to one of the preceding claims, **characterized in that** in the second step of the method the amplitude ratio of said periodic control voltages (U₁₁, U₁₂) is starting out from a first value continuously changed to a second value, where the first value preferably corresponds to the amplitude ratio of said periodic control voltages (U₁₁, U₁₂) in the first step.

6. Method according to one of the preceding claims **characterized in that** in the first step and/or in the second step of the method said periodic control voltages (U₁₁, U₁₂) have substantially the same or exactly the same frequency, where this frequency is outside or preferably close to the electrical resonance frequency of a piezoceramic element of said piezoelectric motor (1) or an ultrasonic actuator in the ultrasonic motor system, respectively.

7. Device for controlling a piezoelectric motor (1) by way of at least two driving electrodes (11, 12) by applying periodic control voltages to said driving electrodes (11, 12), **characterized in that** said device is configured as to automatically carry out the method according to one of the preceding claims.

8. Device according to claim 7, **characterized in that** said device comprises a control device which is configured to first apply said periodic control voltages (U₁₁, U₁₂) with a phase shift to said driving electrodes (11, 12) and then to change the amplitude ratio of said periodic control voltages (U₁₁, U₁₂) with respect to the first step, preferably when propulsion of said piezoelectric motor (1) is requested.

## Revendications

1. Procédé pour assurer la commande de fonctionnement d'un moteur piézoélectrique (1) comprenant au moins deux électrodes de commande (11, 12), par application de tensions de commande périodiques aux électrodes de commande (11, 12), procédé d'après lequel dans une première étape du procédé, les tensions de commande périodiques (U₁₁, U₁₂) sont appliquées avec un décalage de phase aux électrodes de commande (11, 12), et dans une deuxième étape du procédé, on fait varier le rapport des amplitudes des tensions de commande périodiques (U₁₁, U₁₂) par rapport à la première étape,
**caractérisé en ce que** dans la première étape du procédé, on règle le décalage de phase et/ou le rapport des amplitudes des tensions de commande périodiques (U₁₁, U₁₂) de manière à réduire le frottement d'adhérence d'un contact de frottement entre un élément de friction (14) du moteur piézoélectrique (1) et un élément de sortie (15) devant être entrainé par l'élément de friction (14), sans produire simultanément une avance de propulsion de l'élément de sortie (15), aucune force de déviation n'agissant sur l'élément de sortie (15) et celui-ci se trouvant en équilibre de force le long de ses degrés de liberté de mouvement, et **en ce que** dans la deuxième étape du procédé, on fait varier le décalage de phase et/ou le rapport des amplitudes des tensions de commande périodiques (U₁₁, U₁₂) par rapport à la première étape, de manière à ce que la trajectoire d'oscillation de l'élément de friction (14) s'incline par rapport à la première étape, en provoquant ainsi une avance de propulsion de l'élément de sortie (15).

2. Procédé selon la revendication 1, **caractérisé en ce que** dans la première étape du procédé, on règle le décalage de phase et/ou le rapport des amplitudes des tensions de commande périodiques (U₁₁, U₁₂) de manière à ce qu'un élément de friction (14) du moteur piézoélectrique (1) soit excité en oscillation le long d'une trajectoire d'oscillation, qui s'étend sensiblement de manière tangentielle ou exactement de manière tangentielle à une surface de friction (17) d'un élément de sortie (15) devant être entrainé par l'élément de friction (14).

3. Procédé selon l'une des revendications précédentes, **caractérisé en ce que** dans la première étape et/ou dans la deuxième étape du procédé, les tensions de commande périodiques (U₁₁, U₁₂) sont appliquées avec un décalage de phase constant aux électrodes de commande (11, 12), le décalage de phase étant de préférence sensiblement égal à 180° ou exactement égal à 180°.

4. Procédé selon l'une des revendications précédentes, **caractérisé en ce que** dans la première étape du procédé, le rapport des amplitudes des tensions de commande périodiques (U₁₁, U₁₂) est constant, de préférence sensiblement égal à 1 ou exactement égal à 1.

5. Procédé selon l'une des revendications précédentes, **caractérisé en ce que** dans la deuxième étape de procédé, on fait varier en continu le rapport des amplitudes des tensions de commande périodiques (U₁₁, U₁₂) à partir d'une première valeur jusqu'à une deuxième valeur, la première valeur correspondant de préférence au rapport des amplitudes des tensions de commande périodiques (U₁₁, U₁₂) dans la première étape du procédé.

6. Procédé selon l'une des revendications précédentes, **caractérisé en ce que** dans la première étape et/ou dans la deuxième étape du procédé, les tensions de commande périodiques (U₁₁, U₁₂) présentent sensiblement la même ou exactement la même fréquence, cette fréquence se situant en-dehors et de préférence à proximité de la fréquence de résonance électrique d'un élément piézo-céramique du moteur piézoélectrique (1) ou respectivement d'un actionneur à ultrasons dans le système de moteur à ultrasons.

7. Dispositif pour assurer la commande de fonctionnement d'un moteur piézoélectrique (1) comprenant au moins deux électrodes de commande (11, 12), par application de tensions de commande périodiques aux électrodes de commande (11, 12), **caractérisé en ce que** le dispositif est configuré pour exécuter automatiquement le procédé selon l'une des revendications précédentes.

8. Dispositif selon la revendication 7, **caractérisé en ce que** le dispositif comporte un appareillage de commande, qui est configuré pour tout d'abord appliquer les tensions de commande périodiques (U₁₁, U₁₂) avec un décalage de phase, aux électrodes de commande (11, 12), et pour ensuite faire varier le rapport des amplitudes des tensions de commande périodiques (U₁₁, U₁₂) par rapport à la première étape, de préférence lorsqu'une avance de propulsion du moteur piézoélectrique (1) est demandée.
